# EUROPEAN PATENT SPECIFICATION

(11) **EP 3 038 150 B1**
(45) Date of publication and mention of the grant of the patent: **03.06.2020**
(21) Application number: 14200073.6
(22) Date of filing: 23.12.2014
(51) Int. Cl.: H01L 23/29, H01L 23/31, H01L 23/528

(54) **Chip scale package with flexible interconnect**
Gehäuse in Chipgröße mit flexibler Verbindung
Boîtier-puce à interconnexion souple

(43) Date of publication of application: 29.06.2016
(73) Proprietor: IMEC VZW, 3001 Leuven (BE)
(72) Inventor: Gonzalez, Mario, 3001 Leuven (BE); Beyne, Eric, 3001 Leuven (BE); De Vos, Joeri, 3001 Leuven (BE)
(74) Representative: Patent Department IMEC

(56) References cited:
- US-A1- 2014 124 940

## Description

### Field

The present disclosure is related to the field of integrated circuit packages, in particular to chip scale packages with flexible interconnect.

### State of the art

Chip scale packages are extensively used in portable applications, because of the small footprint they provide. The small footprint reduces the length of the interconnect and allows for higher frequency and low-power interconnect from the chip to the next level of assembly. The height and weight reduction is an advantage enabling smaller and lighter portable devices.

At the 10th International conference Thermal, Mechanical and Multi-Physics simulation and Experiments in Microelectronics and Microsystems, 2009, the paper "Design study of the Bump on Flexible Lead by FEA for Wafer Level packaging" by I. Eidner was presented, further referenced in this application as: Eidner paper.

The Eidner paper discloses a chip to Printed Circuit Board (PCB) interconnect technology that uses flexible interconnect structures to accommodate the mismatch in Coefficient of Thermal Expansion (CTE) between the chip and the PCB. A lead free bump is placed on a flexible lead to achieve high flexibility. The flexible lead is a copper (Cu) lead, formed in the Re-Distribution Layer (RDL) and embedded in a polyimide bridge, which is isolated from its surroundings and located over an air gap. The polyimide is being formed on the chip. The air gap is located between the chip and the flexible lead. The flexible lead accommodates the CTE mismatch stress and reduces the risk on failures related to CTE mismatch.
The proposed solution in the Eidner paper requires the formation of an isolated "banana shaped" polyimide bridge located over an air gap. A Cu sacrificial layer is used to create the air gap, this sacrificial layer occupies a large area. The air gap excludes the use of die pads, for connections to bumps, thus limiting the bump density. A structure is required that further improves the stress absorption and/or further offers high bump density.

Document US 2014/0124940 A1 relates to flexible routing for chip on board applications. A semiconductor device includes an array of conductive pads for signals. One or more non-linear compliant springs may be present to route signals from the conductive pads to interconnect pads formed on the semiconductor device to attach bump interconnects. The semiconductor device may be mounted to a circuit board by the bump interconnects. When the semiconductor device operates, heat may be generated by the semiconductor device, causing thermal expansion by the semiconductor device and the circuit board. The non-linear compliant springs provide for compliance between the conductive pads and bump interconnects to allow for the different rates of expansion.

### Summary

The object of the of the present invention is achieved by the independent claims. Specific embodiments are defined by the dependent claims.

All following occurrences of the words "embodiment(s)", if referring to feature combinations different from those defined by the independent claims, refer to examples which were originally filed but which do not represent embodiments of the presently claimed invention; these examples are still shown for illustrative purposes only. The present disclosure is related to integrated circuit packages, in particular to Chip Scale Packages (CSP). The CSP comprises a flexible interconnect structure according to embodiments of the present disclosure. The present disclosure is also related to a method for fabricating such CSP. The present disclosure is related to electronic devices that comprise such CSP.

In a first aspect the present disclosure relates to, a chip scale package comprising: a substrate with a contact pad at a first main surface, a flexible interconnect structure and a bonding structure. The flexible interconnect structure comprising: a first dielectric layer on top of the first main surface of the substrate; a first via electrically contacting the contact pad. The first via extending from the contact pad through the first dielectric layer to a first planar upper main surface of the first dielectric layer. The flexible interconnect structure further comprising a planar metal spring on top of the first planar upper main surface electrically contacting the first via, at a first end of the planar metal spring. The flexible interconnect structure further comprising: a second dielectric layer on top of the first dielectric layer, and a second via electrically contacting the planar metal spring, at a second end of the planar metal spring. The second dielectric layer covering the planar metal spring. The second via extending from the planar metal spring through the second dielectric layer to a second planar upper main surface of the second dielectric layer. The flexible interconnect structure further comprising a second metal on top of the second planar upper main surface. The second metal electrically contacting the second via. The bonding structure on top of the flexible interconnect structure, electrically contacting the second metal. The first and second dielectric layers of the flexible interconnect structure have an elastic modulus below 200MPa. Such CSP yield highly flexible interconnect fully embedded in the first and second dielectric, without the need to further improve the elasticity by the use of an air gap under or around the flexible interconnect. A displacement, of the second end with respect to the first end, of the planar metal spring, in a plane of the planar spring can be absorbed by the dielectric layers thanks to their low elastic modulus.

The chip scale package according to embodiments of the present disclosure, wherein the first and second dielectric layers are a polymer.

The chip scale package according to embodiments of the present disclosure, wherein the shape of the planar metal spring is adapted to deform when the first end and the second end are displaced from each other, in any direction, in a plane of the first planar upper main surface. It has been found that larger displacements may be accommodated by adapting the planar metal spring to deform when the first end and the second end are displaced from each other, in any direction, in a plane of the first planar upper main surface.

The chip scale package according to embodiments of the present disclosure, wherein the planar metal spring is curved. Such curved planar metal springs distribute stress evenly within the spring, preventing local concentration of stress. The stress is due to displacement of the endpoints of the planar metal spring.

The chip scale package according to embodiments of the present disclosure, wherein the planar metal spring has a height **H1**, perpendicular to a line between the first end and the second end of the planar metal spring, the height **H1** is at least 30% of the largest distance between any two points of the planar metal spring. It has been found that such planar spring embedded in the first and second dielectrics can accommodate a substantial displacement in a compact structure.

The chip scale package according to embodiments of the present disclosure, wherein the planar metal spring has a height **H1**, perpendicular to a line between the first end and the second end of the planar metal spring, the height **H1** is at least 30% of the corresponding section of the line 21 delimited by each inner side of the planar metal spring. It has been found that such planar spring embedded in the first and second dielectrics can accommodate a substantial displacement in a compact structure.

A chip scale package according to embodiments of the present disclosure, wherein the orthogonal projection of the bonding structure on the first main surface overlaps the contact pad. Such overlap may reduce the footprint of the flexible interconnect structure , and may allow for compact structures to be formed.

A chip scale package according to embodiments of the present disclosure, wherein the bonding structure is centred with the first via in a direction perpendicular to the first main surface. Such centring further reduces the footprint of the interconnect.

The chip scale package according to any of the preceding claims, having a plurality of contact pads in a regular pattern with a pitch **P1**, each contact pad connected to a corresponding bonding structure with a corresponding flexible interconnect structure, wherein the distance **L1** between the first end and second end of the corresponding planar metal spring is at least 0.705 times the pitch **P1**. Such planar metal spring can have high bonding structure density.

In a second aspect the present disclosure is related to an electronic device comprising a chip scale package according to the first aspect of the present disclosure, wherein the chip scale package is bonded to an second substrate through a bonded structure of the chip scale package.

In a third aspect the present disclosure is related to a method for fabricating a chip scale package, the method comprising: providing a substrate with a contact pad at a first main surface ; depositing a first dielectric layer on top of the first main surface, the first dielectric layer has an elastic modulus below 200MPa and has a first planar upper main surface; providing a first via hole in the first dielectric layer exposing at least part of the contact pad; providing a first photo mask on top of the first planar upper main surface of the first dielectric layer, the first photo mask defining a spring shape opening having a first end on the location of the first via hole; depositing a metal in the first via hole and in the spring shape opening, thereby forming a first via and a planar metal spring, the planar metal spring electrically contacting the contact pad through the first via; removing the first photo mask and thereafter depositing a second dielectric layer on top of the first dielectric layer, the second dielectric layer has an elastic modulus below 200MPa and covers the planar metal spring; providing a second via hole in the second dielectric layer exposing a second end of the planar metal spring; providing a second photo mask on top of a second planar upper main surface of the second dielectric layer, the second photo mask defining a second metal shape opening enclosing the second via hole; depositing a metal in the second via hole and in the second metal shape opening, thereby forming a second via and a second metal on the second planar upper main surface, the second metal electrically contacting the second via; removing the second photo mask and thereafter depositing a bonding structure on top of and in electrical contact with the second metal.

### Brief description of the figures

FIG 1 illustrates a cross section of a CSP according to an exemplary embodiments of the present disclosure.
FIG 2 illustrates a three dimensional view of the conductive part of the flexible interconnect structure and the bonding structure according to an exemplary embodiments of the present disclosure.
FIG 3 illustrates a bottom view of the conductive part of the flexible interconnect according to an exemplary embodiments of the present disclosure.
FIG 4 illustrates a planar metal spring according to an exemplary embodiments of the current disclosure.
FIG 5 illustrates a top view of the second metal and the bonding structure according to an exemplary embodiments of the current disclosure.
FIG 6 illustrates a top view of part of a CSP according to an exemplary embodiments of the current disclosure, with a multitude of flexible interconnects and associated bonding structures arranged in a regular pattern of contact pads with a pitch P1.

### Detailed description

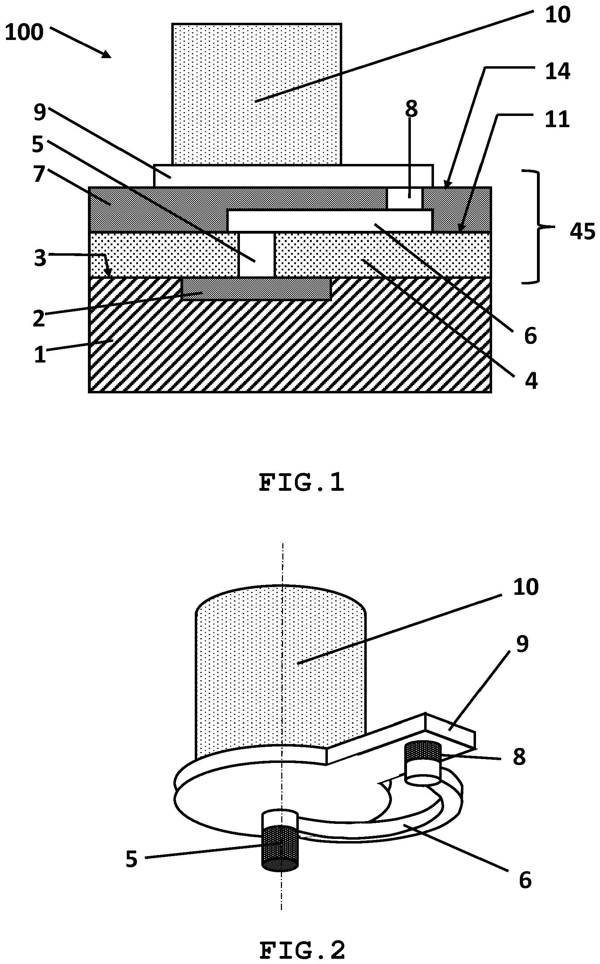

FIG 1 shows a chip scale package **100** that comprises a substrate 1 with a contact pad **2** at a first main surface **3**, a flexible interconnect structure **45** and a bonding structure **10**. The substrate **1** may be a semiconductor integrated circuit, comprising a Front End Of Line (FEOL) and a Back End Of Line (BEOL). The substrate **1** may be a semiconductor interposer. The substrate **1** may be a semiconductor wafer, for example a Silicon wafer. The substrate **1** has a first Coefficient of Thermal Expansion (CTE). The contact pad **2** is a conductive pad. The contact pad **2** may be a metal or metal alloy, for example but not limited to: Cu, Al, Cu alloys or Al alloys. The contact pad **2** is present at the main surface **3** of the substrate **1**. The contact pad **2** may be connected to the BEOL. The contact pad **2** may be connected to a Through Substrate Via (TSV). The main surface of the substrate **1** can be a passivation layer, well known to the skilled person.

The flexible interconnect structure **45** comprises a first dielectric layer **4** on top of the first main surface **3** of the substrate **1**, a first via **5** electrically contacts the contact pad **2**. The first via **5** extends from the contact pad **2** through the first dielectric layer **4** to a first planar upper main surface **11** of the first dielectric layer **4**. The flexible interconnect structure **45** further comprises a planar metal spring **6**, located on top of the first planar upper main surface 11, that electrically contacts the first via **5**, at a first end **12** of the planar metal spring **6**. The flexible interconnect structure **45** further comprises a second dielectric layer **7** located on top of the first dielectric layer **4**, and a second via **5** electrically contacts the planar metal spring **6**, at a second end **13** of the planar metal spring **6**. The second dielectric layer **7** covers the planar metal spring **6**. A second via **8** extends from the planar metal spring **6** through the second dielectric layer **7** to a second planar upper main surface **14** of the second dielectric layer **7**. The flexible interconnect structure **45** further comprises a second metal **9** located on top of the second planar upper main surface **14**. The second metal **9** electrically contacts the second via **8**. A bonding structure **10** located on top of the flexible interconnect structure **45** electrically contacts the second metal **9**. According to embodiments, the first and second dielectric layers **4,7** of the flexible interconnect structure **45** have an elastic modulus below 200MPa. Such flexible interconnect structure **45**, may yield an interconnect structure that are highly flexible owing to the low elastic modulus of the first and second dielectric **4,7**. Such flexible interconnects structure **45** may have the first and second dielectrics **4,7** continuous around an embedded conductive part of the flexible interconnect structure **45**. The first and second dielectrics **4,7** may be advantageously an elastic material, that returns to its initial state after deformation. The first and second dielectrics **4,7** may be advantageously equal in thickness. The first and second dielectrics **4,7** may be advantageously arranged such that the thickness, from the planar metal spring **6** to the second planar upper main surface **14,** is equal to the thickness, from the planar metal spring **6** to the first main surface **3**. The first and second dielectrics **4,7** may be advantageously the same material. According to embodiments, FIG 2 shows the embedded conductive part of the flexible interconnect structure **45** that comprises the first and second via **5,8** and the planar metal spring **6**. The second metal 9 completes the conductive part of the flexible interconnect structure **45**. Such flexible interconnect structure **45** may have their equivalent elastic modulus substantially similar to the elastic modulus of the first and second dielectric layer. Compared to the Eidner prior art, which uses a polyimide as first and second dielectric which have an elastic modulus of 2500MPa, such flexible interconnect structures **45** according to an exemplary embodiment of the present disclosure results in interconnect structures that are more flexible than the Eidner prior art. In an embodiment the first dielectric layer **4** does not contain air gaps or air cavities. In an embodiment the second dielectric layer **7** does not contain air gaps. Air gaps are known to locally lower the elastic modulus to realize a flexible interconnect structure as in the Eidner prior art. Air gaps are not desirable in packaging as they are thermal isolators, and reduce the cooling. It should be noted that the first main surface **3,** the first planar upper main surface **11** and the second planar upper main surface **14**, are substantially parallel. The planar metal spring **6** is made from metal, advantageously the metal is Cu or a Cu alloy. The planar metal spring **6** is substantially planar as it is made on a first planar upper main surface **11** that has a substantially planar surface. When not stressed the planar metal spring **6** may be substantially planar, and has two parallel sides in that are substantially planar. The first and second via **5,8** are made from metal, advantageously the metal is Cu or a Cu alloy. The second metal **9** may be substantially planar as it is made on a second planar upper main surface **14** that may have a substantially planar surface.

According to some embodiments, the first and second dielectric layers may be a polymer. The polymer may be a silicone. The elongation to break of the polymer may advantageously be above 30%. The polymer may advantageously be a photo defined polymer. The polymer may advantageously be an elastic material so that it returns to its initial state after deformation. The thickness of the polymer is advantageously selected so that for a given displacement the elongation to break is not reached. Thin polymer layers may for a given displacement elongate beyond the elongation to break, and break. Thicker polymer layers undergo smaller elongation for the same given displacement and may not be elongated beyond the elongation to break.

According to embodiments, the shape of the planar metal spring **6** is adapted to deform when the first end **12** and the second end **13** are displaced from each other, in any direction, in a plane of the first planar upper main surface **11**. Such planar metal spring wherein the first end **12** and the second end **13** of the planar metal spring **6** are the location where the planar metal spring **6** is attached to the first and second via **5,8**. The first and second via **5,8** terminating the embedded conductive part of the flexible interconnect structure **45**. The terminating ends of the first and second via **5,8** are distant from the planar metal spring. Under the influence of a first force, for example the result of thermal expansion, a displacement may occur at the terminating ends. This displacement is transferred to the first and second end **12,13** of the planar metal spring 6 through the first and second via **5,8** respectively. The transferred displacement may be substantially a planar displacement of the first and second end **12,13** of the planar metal spring **6** in any direction in the plane of the planar metal spring **6.** The planar metal spring **6** is adapted to deform under the transferred displacement, causing a first deformation of the planar metal spring **6**. Such first deformation is enabled by the low stiffness of the metal planar spring **6**. Advantageously the stiffness of the flexible interconnect structure **45** is substantially defined by the stiffness the first and second dielectric **4,7** embedding or surrounding the planar metal spring **6**, and substantially not defined by the stiffness of the planar metal spring **6**.

It will be clear to the skilled person that a second deformation of the flexible interconnect structure **45** may exist perpendicular to the plane of the planar metal spring **6**. Such second deformation, may be caused by the moment of force, or torque, related to the first force which may be applied, for example, on the terminating ends of the first and second via **5,8**. The second deformation, may be caused by other forces. Nevertheless such second deformation is typically not limiting for embodiments of the present disclosure. In some embodiments, the second deformation may be lower than the first deformation. It will be clear to the skilled person that the value of the second deformation may depend on the material that optionally covers at least partially the second planar upper main surface **14** and the second metal **9**.

According to embodiments, the planar metal spring **6** is curved. Such curved planar metal spring distribute stress evenly within the spring, preventing local concentration of stress. The stress may be due to the transferred displacement causing a first deformation of the planar metal spring **6**. The stress may be compressive in some locations of the planar metal spring. The stress may be tensile in some locations of the planar metal spring.

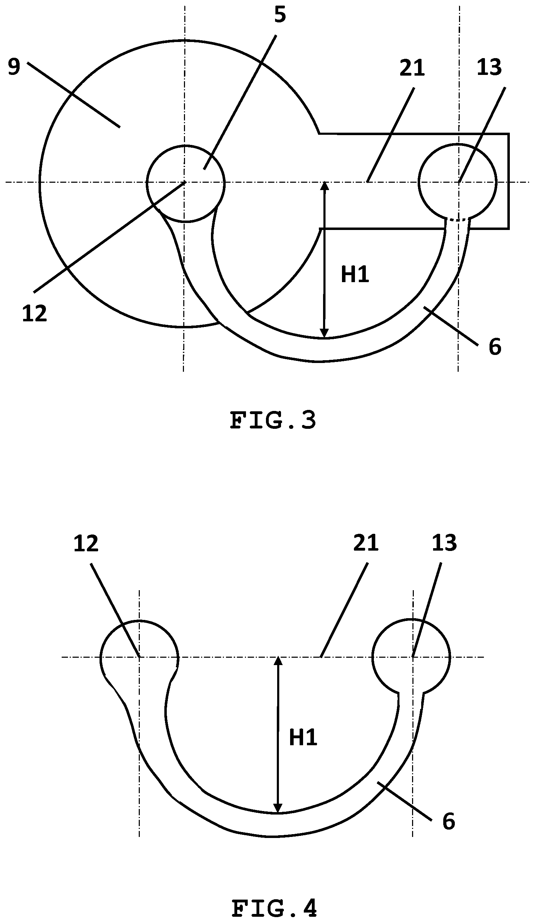

According to embodiments illustrated in FIG 3 and FIG 4, the planar metal **6** spring has a height **H1**, perpendicular to a straight line **21** between the first end **12** and the second end **13** of the planar metal spring **6**, of at least 30% of the corresponding section of the line **21** enclosed by each inner side of the planar metal spring **6**. Such height **H1** is measured as the distance from the line **21** to an inner point of the planar metal spring **6**. Such planar metal spring **6** may include meander-type (not shown) metal planar spring **6**, that has at least two inner sides that each enclose a unique section of the line **21**. Each unique section of the line **21**, is enclosed and delimited by a single inner side of the planar metal spring **6**, and must have at least one height **H1** of at least 30% of the distance of that section of the line **21**.

According to embodiments, the planar metal **6** spring has a height **H1**, perpendicular to a straight line **21** between the first end **12** and the second end **13** of the planar metal spring **6**, of at least 30% of the largest distance between any two points of the planar metal spring **6**. Such planar metal springs **6** may include single curve springs that have sufficient elongation to break. Advantageously the height **H1** is 40% of the largest distance between any two points of the planar metal spring **6.** More advantageously the height **H1** at least 50% of the largest distance between any two points of the planar metal spring **6**. It should be noted that a larger height allows a larger elongation for a given distance **L1** between the first end **12** and second end **13** of the planar metal spring **6**.

According to embodiments, the orthogonal projection of the bonding structure **10** on the first main surface **3** overlaps the contact pad **2**. Such overlap may reduce the footprint of the flexible interconnect structure **45**, and may allow for compact structures to be formed around the contact pad **2**.

According to embodiments, the bonding structure **10** is centred with the first via **3** in a direction perpendicular to the first main surface **3**. Such centring further reduces the footprint of the flexible interconnect structure **45** around the contact pad **2**. FIG 2 illustrates an embodiments of such a centring, the conductive part of the flexible interconnect structure **45** and the bonding structure **10** are shown, the first via **3** is shown with its centre aligned with the centre of the bonding structure **10** as illustrated by the dotted axis line in FIG 2.

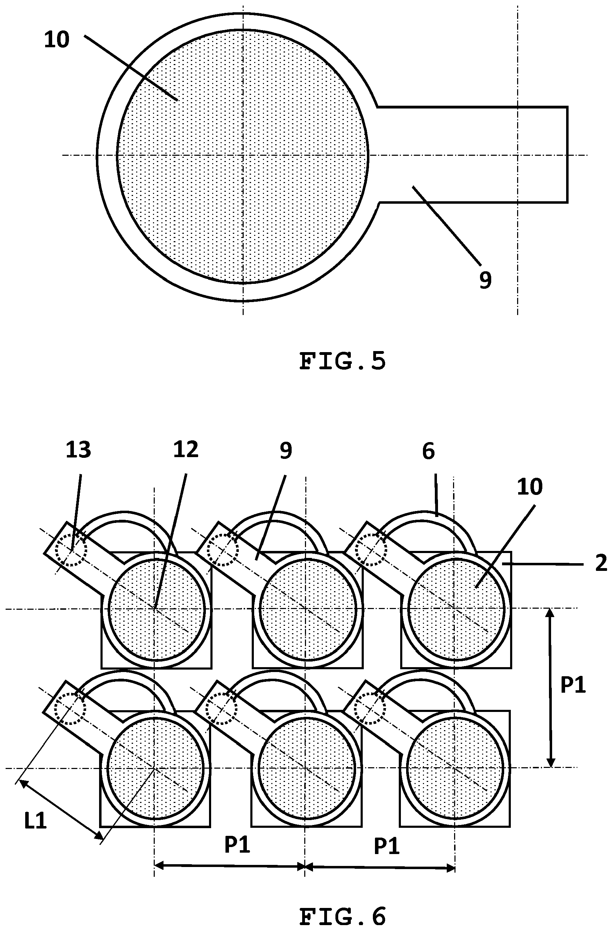

According to embodiments, the chip scale package **100** as illustrated in FIG 6. has a plurality of contact pads **2** in a regular two dimensional pattern with a single pitch **P1**, each contact pad **2** connected to a corresponding bonding structure **10** with a corresponding flexible interconnect structure **45**, wherein the distance **L1** between the first end **12** and second end **13** of the corresponding planar metal spring **6** is at least 0.705 times the pitch **P1**. Such distance **L1** between the first end **12** and second end **13** of the corresponding planar metal spring **6** may be realized by placing the planar metal spring **6** at an angle with respect to the direction of the pitch **P1**. Such planar metal spring **6** can have high bonding structure density at a pitch **P1** combined with a displacement that can be equally displaced in all directions of the plane of the planar metal spring **6**. Such planar metal spring **6** has the second end **13** of the planar metal spring **6** in the centre of the four neighbouring first via **3**. Advantageously such distance **L1** between the first end **12** and second end **13** of the corresponding planar metal spring **6** may be combined with a height **H1** of the planar metal spring **6** that uses the space between neighbouring planar metal springs. Such planar metal spring can have high bonding structure density combined with long elongation to break. Advantageously the distance **L1** between the first end **12** and second end **13** of the corresponding planar metal spring **6** is at least equal to the pitch **P1** further enlarging the elongation to break of the spring for a given height **H1** and maintaining high bonding structure density.

According to embodiments, the bonding structure **10** comprises a metal pillar as shown in FIG 2 and FIG 5. Such metal pillars may be used in Thermo Compression Bonding (TCB). It is an advantage that TCB may be used on CSP with flexible interconnect structures according to embodiments of the present disclosure.

According to embodiments the CSP, wherein the bonding structure **10** comprises a solder material.

In an exemplary embodiment the CSP has a Si substrate **1**, a 10µm thick first and second dielectric **3,7** made of Silicone that has an elastic modulus of 29MPa at room temperature, a Cu first and second via **5,8** with a diameter of 15µm, a planar metal spring **6** made of Cu having a thickness of 5µm and a curved shape of 5µm wide with a height **H1** of 30µm with a single inner surface, a second metal made of Cu with a thickness of 5µm, a bonding structure that is a Cu pillar of 50µm height, 50µm diameter and a pitch P1 of 80µm. A displacement of 10µm between the first and second via **5,8** may be absorbed with low stress in the conductive part of the flexible interconnect structure.

In a second aspect the present disclosure relates to an electronic device, comprising a chip scale package (CSP) **100** according to the first aspect of the present disclosure, wherein the chip scale package **100** is bonded to a second substrate through a bonding structure **10** of the chip scale package. The second substrate may be for example an organic substrates, other substrates are possible and known to the skilled person in the art. The flexible interconnect **45** may absorb a given displacement between the first and second substrate. The flexible interconnect **45** may advantageously absorb a given displacement between the first and second substrate in a plane of the planar metal spring **6** of the flexible interconnect **45**. The given displacement may be caused by for example: vibrations, accelerations or decelerations caused for instance by dropping the electronic device on the floor. The space in between the second substrate and the interconnect structure **45** of the CSP, contains a bonded structure and may be filled with Under Fill (UF) material well known to the skilled person in the art. The UF may for example be used in Thermo Compression Bonding (TCB) using Cu pillars used as bonding structure **10** on the CSP. Bonding techniques are well known in the art and will not be detailed. It will be clear that once the electronic device has the first and second substrate bonded, the bonding structure **10** of the CSP is bonded with its counterpart on the second substrate, together forming a bonded structure.

According to embodiments, the second substrate has a second Coefficient of Thermal Expansion (CTE) substantially different from the first CTE of the substrate 1 of the CSP. The substantial difference in CTE may cause the given displacement and create shear stress between the substrate **1** and the second substrate, that is advantageously absorbed by the flexible interconnect **45**. A given displacement by the CTE may be caused by a temperature excursion that makes the first and second substrate expand in size at different rates. The substrate **1**, for example a large first Si substrate of 15mm by 15mm, bonded to the second substrate for example an organic Printed Circuit Board (PCB) with a CTE of 7ppm/°C, wherein a 200°C temperature excursion may cause a given displacement of almost 10µm from the center of the substrate **1** to a corner of the substrate **1**. The rigid bonded structure may undergo shear stress caused by the given displacement and may break. The flexible interconnect according to embodiments of the present disclosure may advantageously absorb part of the stress and relieve the bonded structures from the large shear stress. The 200°C excursion can for instance occur during reflow bonding with a solder. Other bonding types may cause large temperature excursions. Optional post bond anneal steps, for example over-molding or under-filling, may cause large temperature excursions of about 180degC.

In a third aspect the present disclosure relates to a method for fabricating a chip scale package **100**, according to the first aspect of the present disclosure, the method comprising: providing a substrate **1** with a contact pad **2** at a first main surface **3**; depositing a first dielectric layer **4** on top of the first main surface 3, the first dielectric layer **4** has an elastic modulus below 200MPa and has a first planar upper main surface **11**; providing a first via hole in the first dielectric layer **4** exposing at least part of the contact pad **2**; providing a first photo mask on top of the first planar upper main surface (11) of the first dielectric layer **4**, the first photo mask defining a spring shape opening having a first end **12** on the location of the first via hole; depositing a metal in the first via hole and in the spring shape opening, thereby forming a first via **5** and a planar metal spring **6**, the planar metal spring **6** electrically contacting the contact pad **2** through the first via **5**; removing the first photo mask and thereafter depositing a second dielectric layer **7** on top of the first dielectric layer **4**, the second dielectric layer **7** has an elastic modulus below 200MPa and covers the planar metal spring **6**; providing a second via hole in the second dielectric layer **7** exposing a second end **13** of the planar metal spring **6**; providing a second photo mask on top of a second planar upper main surface **14** of the second dielectric layer **7**, the second photo mask defining a second metal shape opening enclosing the second via hole; depositing a metal in the second via hole and in the second metal shape opening, thereby forming a second via **8** and a second metal **9** on the second planar upper main surface **14**, the second metal **9** electrically contacting the second via **8;** removing the second photo mask and thereafter depositing a bonding structure (10) on top of and in electrical contact with the second metal **9**.

According to embodiments, the step of depositing the first and second dielectric may advantageously be a step of spinning on a dielectric. Such spin on technique allows for substantially planar upper surface. It should be noted that small variations in planarity may exist, such variations are typically not limiting for embodiments of the present disclosure.

According to embodiments, the step of depositing the metal to form the first via, the planar metal spring, the second via and the second metal, may be a plating step to deposit the metal. The metal plated is advantageously Cu. The plating process is well known to the skilled person and will not be detailed.

According to embodiments, the step of providing a first and second via hole, can be advantageously performed on a photo-patternable dielectric layer as known in the art.

## Claims

1. A chip scale package (100) comprising:
- a substrate (1) with a contact pad (2) at a first main surface (3); and
- a flexible interconnect structure (45), comprising:
- a first dielectric layer (4) on top of the first main surface (3);
- a first via (5) electrically contacting the contact pad (2), the first via (5) extending from the contact pad (2) through the first dielectric layer (4) to a first planar upper main surface (11) of the first dielectric layer (4);
- a planar metal spring (6) on top of the first planar upper main surface (11) electrically contacting the first via (5) at a first end (12) of the planar metal spring (6);
- a second dielectric layer (7) on top of the first dielectric layer (4) and covering the planar metal spring (6);
- a second via (8) electrically contacting at a second end (13) of the planar metal spring (6), the second via (8) extending from the planar metal spring (6) through the second dielectric layer (7) to a second planar upper main surface (14) of the second dielectric layer (7);
- a second metal (9) on top of the second planar upper main surface (14) and electrically contacting the second via (8);
wherein the first and second dielectric layers (4,7) of the flexible interconnect structure (45) have an elastic modulus below 200MPa; and
- a bonding structure (10) on top of the flexible interconnect structure (45), electrically contacting the second metal (9);
**characterized in that** the orthogonal projection of the bonding structure (10) on the first main surface (3) overlaps the contact pad (2).

2. The chip scale package (100) according to claim 1, wherein the first and second dielectric layers (4,7) are a polymer.

3. The chip scale package (100) according to any of the preceding claims, wherein the planar metal spring (6) is a meander type metal spring, the meander type metal spring has at least two inner sides that each enclose a unique section of a line 21 between the first end (12) and the second end (13) of the planar metal spring (6) and wherein each of the inner sides has a height H1, measured perpendicular to the line (21), of at least 30% of the corresponding unique section of the line (21).

4. The chip scale package (100) according to any of the preceding claims, wherein the bonding structure (10) is centred with the first via (3) in a direction perpendicular to the first main surface (3).

5. The chip scale package (100) according to any of the preceding claims, having a plurality of contact pads (2) in a regular pattern with a pitch (P1), each contact pad (2) connected to a corresponding bonding structure (10) with a corresponding flexible interconnect structure (45), wherein the distance (L1) between the first end (12) and second end (13) of the corresponding planar metal spring (6) is at least 0.705 times the pitch (P1).

6. An electronic device comprising the chip scale package (100) according to any of the preceding claims, wherein the chip scale package is bonded to a second substrate through a bonded structure of the chip scale package.

## Patentansprüche

1. Chip-Scale-Package (100), umfassend:
- ein Substrat (1) mit einem Kontaktpad (2) an einer ersten Hauptoberfläche (3); und
- eine flexible Leiterbahnstruktur (45), umfassend:
- eine erste dielektrische Schicht (4) oben auf der ersten Hauptoberfläche (3);
- ein erstes Durchgangsloch (5), das das Kontaktpad (2) elektrisch kontaktiert, wobei sich das erste Durchgangsloch (5) von der Kontaktfläche (2) durch die erste dielektrische Schicht (4) zu einer ersten planaren oberen Hauptoberfläche (11) der ersten dielektrischen Schicht (4) erstreckt;
- eine planare Metallfeder (6) oben auf der ersten planaren oberen Hauptoberfläche (11), die das erste Durchgangsloch (5) an einem ersten Ende (12) der planaren Metallfeder (6) elektrisch kontaktiert;
- eine zweite dielektrische Schicht (7) oben auf der ersten dielektrischen Schicht (4), die die planare Metallfeder (6) bedeckt;
- eine zweites Durchgangsloch (8), das an einem zweiten Ende (13) der planaren Metallfeder (6) elektrisch kontaktiert, wobei sich das zweite Durchgangsloch (8) von der planaren Metallfeder (6) durch die zweite dielektrische Schicht (7) zu einer zweiten planaren oberen Hauptoberfläche (14) der zweiten dielektrischen Schicht (7) erstreckt;
- ein zweites Metall (9) oben auf der zweiten planaren oberen Hauptoberfläche (14), das das zweite Durchgangsloch (8) elektrisch kontaktiert;
wobei die erste und zweite dielektrische Schicht (4,7) der flexiblen Leiterbahnstruktur (45) einen Elastizitätsmodul unter 200 MPa aufweisen; und
- eine Verbindungsstruktur (10) oben auf der flexiblen Leiterbahnstruktur (45), die das zweite Metall (9) elektrisch kontaktiert;
**dadurch gekennzeichnet, dass** der orthogonale Vorsprung der Verbindungsstruktur (10) auf der ersten Hauptoberfläche (3) sich mit dem Kontaktpad (2) überlappt.

2. Chip-Scale-Package (100) nach Anspruch 1, wobei die erste und zweite dielektrische Schicht (4,7) ein Polymer sind.

3. Chip-Scale-Package (100) nach einem der vorstehenden Ansprüche, wobei die planare Metallfeder (6) eine mäanderartige Metallfeder ist, wobei die mäanderartige Metallfeder mindestens zwei Innenseiten aufweist, die jeweils einen eindeutigen Abschnitt einer Linie (21) zwischen dem ersten Ende (12) und dem zweiten Ende (13) der planaren Metallfeder (6) umschließen, und wobei jede der Innenseiten eine Höhe H1, gemessen senkrecht zu der Linie (21), von mindestens 30% des entsprechenden eindeutigen Abschnitts der Linie (21) aufweist.

4. Chip-Scale-Package (100) nach einem der vorstehenden Ansprüche, wobei die Verbindungsstruktur (10) mit dem ersten Durchgangsloch (3) in einer Richtung senkrecht zur ersten Hauptoberfläche (3) zentriert ist.

5. Chip-Scale-Package (100) nach einem der vorstehenden Ansprüche, aufweisend eine Vielzahl von Kontaktpads (2) in einem regelmäßigen Muster mit einem Pitch (P1), wobei jedes Kontaktpad (2) mit einer entsprechenden Verbindungsstruktur (10) mit einer entsprechenden flexiblen Leiterbahnstruktur (45) verbunden ist, wobei der Abstand (L1) zwischen dem ersten Ende (12) und dem zweiten Ende (13) der entsprechenden planaren Metallfeder (6) mindestens das 0,705-fache des Pitch (P1) beträgt.

6. Elektronische Vorrichtung, umfassend das Chip-Scale-Package (100) nach einem der vorstehenden Ansprüche, wobei das Chip-Scale-Package durch eine Verbundstruktur des Chip-Scale-Package mit einem zweiten Substrat verbunden ist.

## Revendications

1. Boîtier-puce (100) comprenant :
- un substrat (1) avec une plage de contact (2) au niveau d'une première surface principale (3) ; et
- une structure à interconnexion souple (45), comprenant :
- une première couche diélectrique (4) en haut de la première surface principale (3) ;
- une première liaison (5) en contact électrique avec la plage de contact (2), la première liaison (5) s'étendant à partir de la plage de contact (2) à travers la première couche diélectrique (4) vers une surface principale supérieure planaire (11) de la première couche diélectrique (4) ;
- un ressort en métal planaire (6) en haut de la première surface principale supérieure planaire (11) en contact électrique avec la première liaison (5) au niveau d'une première extrémité (12) du ressort en métal planaire (6) ;
- une seconde couche diélectrique (7) en haut de la première couche diélectrique (4) et couvrant le ressort en métal planaire (6) ;
- une seconde liaison (8) en contact électrique au niveau d'une seconde extrémité (13) du ressort en métal planaire (6), la seconde liaison (8) s'étendant à partir du ressort en métal planaire (6) à travers la seconde couche diélectrique (7) vers une seconde surface principale supérieure planaire (14) de la seconde couche diélectrique (7) ;
- un second métal (9) en haut de la seconde surface principale supérieure planaire (14) et en contact électrique avec la seconde liaison (8) ;
dans lequel les première et seconde couches diélectriques (4, 7) de la structure à interconnexion souple (45) présentent un module élastique en dessous de 200 MPa ; et
- une structure de liaison (10) en haut de la structure à interconnexion souple (45), en contact électrique avec le second métal (9) ;
**caractérisé en ce que** la projection orthogonale de la structure de liaison (10) sur la première surface principale (3) chevauche la plage de contact (2).

2. Boîtier-puce (100) selon la revendication 1, dans lequel les première et seconde couches diélectriques (4, 7) sont un polymère.

3. Boîtier-puce (100) selon l'une quelconque des revendications précédentes, dans lequel le ressort en métal planaire (6) est un ressort en métal de type serpentant, le ressort en métal de type serpentant présente au moins deux côtés intérieurs qui renferment chacun une section unique d'une ligne (21) entre la première extrémité (12) et la seconde extrémité (13) du ressort en métal planaire (6) et dans lequel chacun des côtés intérieurs présente une hauteur H1, mesurée perpendiculairement à la ligne (21), d'au moins 30 % de la section unique de la ligne (21) correspondante.

4. Boîtier-puce (100) selon l'une quelconque des revendications précédentes, dans lequel la structure de liaison (10) est centrée avec la première liaison (3) dans une direction perpendiculaire à la première surface principale (3).

5. Boîtier-puce (100) selon l'une quelconque des revendications précédentes, présentant une pluralité de plages de contact (2) selon un motif régulier avec un pas (P1), chaque plage de contact (2) étant connectée à une structure de liaison (10) correspondante avec une structure à interconnexion souple (45) correspondante, dans lequel la distance (L1) entre la première extrémité (12) et la seconde extrémité (13) du ressort en métal planaire (6) correspondant est d'au moins 0,705 fois le pas (P1).

6. Dispositif électronique comprenant le boîtier-puce (100) selon l'une quelconque des revendications précédentes, dans lequel le boîtier-puce est relié à un second substrat au moyen d'une structure de liaison du boîtier-puce.
